# EUROPEAN PATENT APPLICATION

(11) **EP 4 804 192 A2**
(43) Date of publication of application: **09.09.2026**
(21) Application number: 25210629.9
(22) Date of filing: 23.10.2025
(51) Int. Cl.: G11C 29/00

(54) **MEMORY DEVICES CONFIGURED TO PERFORM A REFRESH OPERATION AND METHOD OF PERFORMING A REFRESH OPERATION WITH A MEMORY DEVICE**

(30) Priority: 04.03.2025 KR 20250027799
(71) Applicant: SK hynix Inc., Bubal-eub Icheon-si Gyeonggi-do 17336 (KR)
(72) Inventor: KIM, Jung Yeon, Icheon-si, Gyeonggi-do (KR); KIM, Seon Yeol, Icheon-si, Gyeonggi-do (KR); YANG, Seng Min, San Jose, CA (US)
(74) Representative: Isarpatent

(57) **Abstract**

A memory device includes an address arithmetic circuit configured to generate a redundancy switching signal when a normal word line connected to a normal cell is designated as a target word line and a redundancy word line connected to a redundancy cell is designated as an adjacent word line so that a smart refresh operation is performed. The memory device also includes a redundancy control circuit configured to generate a redundancy activation signal based on the redundancy switching signal.

## Description

### BACKGROUND

### 1. Technical Field

The present disclosure generally relates to memory devices, and more particularly, to a memory device configured to perform a refresh operation and methods of performing the refresh operation with a memory device.

### 2. Related Art

A memory device has a number of memory cells for storing data. Each memory cell includes a cell capacitor and a cell transistor. A memory device stores data by charging or discharging the cell capacitor, and an amount of charge stored in the cell capacitor is always constant. However, the amount of charge stored in the cell capacitor is changed due to voltage difference from peripheral circuits. This change in the amount of charge in the cell capacitor means that data stored in the cell capacitor is changed, which means that the stored data is lost. The memory device performs a refresh operation to prevent data loss.

### SUMMARY

The present disclosure, according to an embodiment, describes a memory device that may include an address arithmetic circuit configured to generate a redundancy switching signal when a normal word line connected to a normal cell is designated as a target word line and a redundancy word line connected to a redundancy cell is designated as an adjacent word line so that a smart refresh operation is performed; and a redundancy control circuit configured to generate a redundancy activation signal based on the redundancy switching signal.

The present disclosure, according to an embodiment, describes a memory device that may include a row hammering control circuit configured to generate an addition signal, a subtraction signal, and a holding signal based on a row hammering control signal, a spacing setting signal, a selection address, and a sequence signal; an arithmetic address generation circuit configured to generate an arithmetic address from the selection address based on the addition signal, the subtraction signal, and the holding signal; and a switching detection circuit configured to generate a redundancy switching signal and a normal switching signal based on the selection address, the addition signal, and the subtraction signal.

The present disclosure describes, according to an embodiment, a method of performing a refresh operation that may include generating a redundancy switching signal as activated for a first smart refresh operation on a first adjacent word line when a target word line is a normal word line and the first adjacent word line is a first redundancy word line located at a set spacing from the target word line; and generating a redundancy activation signal as activated for the first smart refresh operation when the redundancy switching signal is activated.

### BRIEF DESCRIPTION OF THE DRAWINGS

FIG. 1 illustrates a memory device according to an embodiment of the present disclosure.
FIG. 2 illustrates an address arithmetic circuit according to an embodiment of the present disclosure.
FIG. 3 is a table showing operations of a row hammering control circuit according to an embodiment of the present disclosure.
FIG. 4 illustrates a redundancy control circuit according to an embodiment of the present disclosure.
FIG. 5 illustrates an input buffer according to an embodiment of the present disclosure.
FIG. 6 illustrates a redundancy detection circuit according to an embodiment of the present disclosure.
FIG. 7 illustrates an example of a first mat control circuit according to an embodiment of the present disclosure.
FIG. 8 illustrates an example of a second mat control circuit according to an embodiment of the present disclosure.
FIG. 9 illustrates an example of a K^{th} mat control circuit according to an embodiment of the present disclosure.
FIG. 10 illustrates an example of a mat synthetic circuit according to an embodiment of the present disclosure.
FIG. 11 illustrates an example of a redundancy activation signal generation circuit according to an embodiment of the present disclosure.
FIG. 12 illustrates a smart refresh operation performed in a mat according to an embodiment of the present disclosure.
FIG. 13 illustrates a smart refresh operation performed in a mat according to an embodiment of the present disclosure.
FIG. 14 illustrates a smart refresh operation performed in a mat according to an embodiment of the present disclosure.
FIG. 15 illustrates a smart refresh operation performed in a mat according to an embodiment of the present disclosure.
FIG. 16 illustrates a smart refresh operation performed in a mat according to an embodiment of the present disclosure.
FIG. 17 illustrates a smart refresh operation performed in a mat according to an embodiment of the present disclosure.
FIG. 18 illustrates a memory system according to an embodiment of the present disclosure.

### DETAILED DESCRIPTION

The present disclosure relates to memory devices that performs a refresh operation and methods of performing the refresh operation. As process technology develops, integration of memory devices gradually increases, so that a spacing between memory cells decreases and the spacing between adjacent word lines connected to the memory cells decreases. When the spacing between adjacent word lines decreases, interference occurs between adjacent word lines, making it difficult to maintain data stored in the memory cells connected to the word lines. That is, probability of data loss increases. Recent memory devices perform additional refresh operations on the word lines adjacent to a target word line where access is concentrated due to the interference between word lines, thereby preventing or mitigating data of the memory cells connected to the adjacent word lines from being lost due to the interference between word lines. The refresh operation performed on the adjacent word line when the target word line is activated is referred to as a "smart refresh operation".

Terms such as "first" and "second" are used to distinguish between various elements and do not imply size, order, priority, quantity, or importance of the elements. For example, a first element may be named as a second element in one example, and the second element may be named as a first element in another example.

When one component is identified as "connected" to another component, the components may be connected directly or through an intervening component between the components. When two components are identified as "directly connected," one component is directly connected to the other component without an intervening component between the two components.

A logic "high" level and a logic "low" level may be used to describe logic levels of electric signals. A signal at a logic high level is distinguished from a signal at a logic low level. For example, when a signal at a first voltage corresponds to a signal at a logic high level, a signal at a second voltage corresponds to a signal at a logic low level. In an embodiment, the logic high level may be a voltage level that is higher than a voltage level of the logic low level. Logic levels of signals may be different or opposite according to the embodiments. For example, a signal at a logic high level in one embodiment may be at a logic low level in another embodiment, and a signal at a logic low level in one embodiment may be at a logic high level in another embodiment.

The term "logic bit set" may mean a combination of logic levels of bits included in a signal. When the logic level of each of the bits included in the signal is changed, the logic bit set of the signal may be set differently. For example, when the signal includes two bits, when the logic level of each of the two bits included in the signal is "logic low level, logic low level", the logic bit set of the signal may be set as the first logic bit set, and when the logic level of each of the two bits included in the signal is "a logic low level and a logic high level", the logic bit set of the signal may be set as the second logic bit set.

Embodiments of the present disclosure are described in detail with reference to the accompanying drawings. Specific structural or functional descriptions of embodiments are provided as examples to describe concepts that are disclosed in the present application. Examples or embodiments in accordance with the concepts may be carried out in various forms, and the scope of the present disclosure is not limited to the examples or embodiments described in this specification.

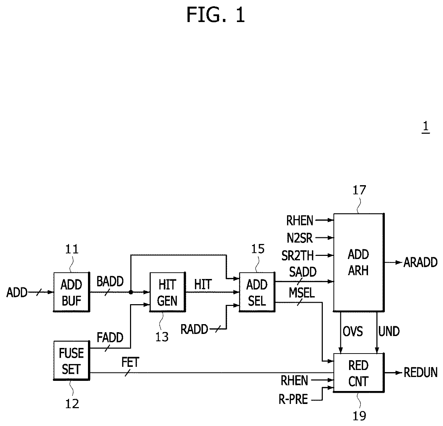

FIG. 1 illustrates a memory device 1 according to an embodiment of the present disclosure.

As shown in FIG. 1, the memory device 1 includes an address buffer (ADD BUF) 11, a fuse set 12, a fail confirmation signal generation circuit (HIT GEN) 13, an address selection circuit (ADD SEL) 15, an address arithmetic circuit (ADD ARH) 17, and a redundancy control circuit (RED CNT) 19.

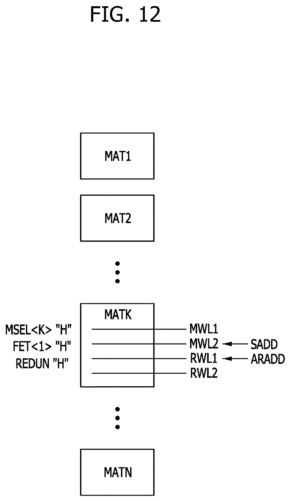

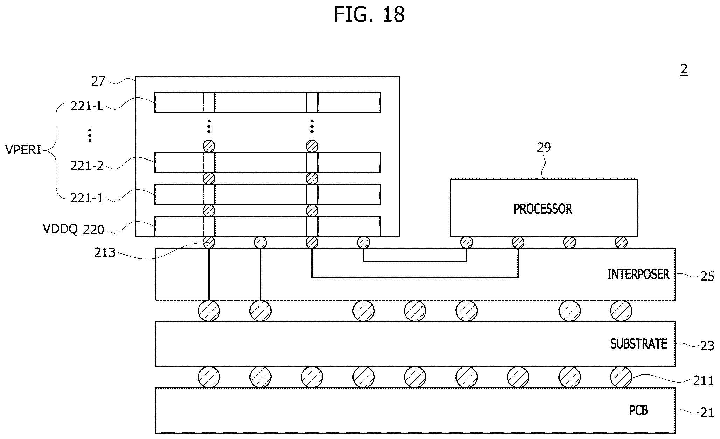

The address buffer 11 receives an externally input address ADD, for example, input from a processor 29 in FIG. 18 for an active operation and a refresh operation. The address ADD includes information used to access memory cells included in each mat, for example, MAT1 to MATK in FIG. 12, when an active operation or a refresh operation is performed. The address buffer 11 buffers the address ADD to generate a buffer address BADD.

The fuse set 12 includes a plurality of programmable fuses. The fuses may be implemented as electric fuses, laser fuses, and anti-fuses. The electric fuses are programmed in a manner that they are cut using high voltage or current, the laser fuses are programmed in a manner that they are cut with a laser during a manufacturing process, and the anti-fuses are programmed in a manner that their electrical properties are changed from non-conductive to conductive by applying high voltage. The fuses included in the fuse set 12 are programmed with information about defective memory cells among the memory cells included in each mat, information about redundancy word lines connected to redundancy cells to replace the defective memory cells by a repair operation, and so forth. The fuse set 12 outputs the information about the defective memory cells stored in the fuses as a fail address FADD and outputs the information about the redundancy word line used in the repair operation as repair information FET.

The fail confirmation signal generation circuit 13 is electrically connected to the address buffer 11 and the fuse set 12, receives the buffer address BADD from the address buffer 11, and receives the fail address FADD from the fuse set 12. The fail confirmation signal generation circuit 13 generates a fail confirmation signal HIT based on the buffer address BADD and the fail address FADD. The fail confirmation signal generation circuit 13 generates the fail confirmation signal HIT as activated at a first logic level when the buffer address BADD obtained by buffering the address ADD received for a refresh operation is the same as the fail address FADD. The fail confirmation signal generation circuit 13 generates the fail confirmation signal HIT as deactivated at a second logic level different from the first logic level when the buffer address BADD is different from the fail address FADD.

The address selection circuit 15 is electrically connected to the address buffer 11 and the fail confirmation signal generation circuit 13, receives the buffer address BADD from the address buffer 11, and receives the fail confirmation signal HIT from the fail confirmation signal generation circuit 13. The address selection circuit 15 generates a selection address SADD and a mat selection signal MSEL from the buffer address BADD and a redundancy address RADD based on the fail confirmation signal HIT. The redundancy address RADD includes information used to access redundancy cells that replace defective memory cells when the memory cells accessed during the active operation or refresh operation are defective. The redundancy address RADD is stored in the fuse set 12 and is provided from the fuse set 12 in this embodiment, and the present disclosure is not limited to this embodiment. When the fail confirmation signal HIT is deactivated, the address selection circuit 15 selects and outputs the buffer address BADD as the selection address SADD and extracts the mat selection signal MSEL used to select a mat on which a refresh operation is performed from the buffer address BADD. The buffer address BADD includes information about the mat that includes the memory cells to be refreshed and main word lines. When the fail confirmation signal HIT is activated, the address selection circuit 15 selects and outputs the redundancy address RADD as the selection address SADD and extracts the mat selection signal MSEL used to select a mat on which a refresh operation is performed from the redundancy address RADD. The redundancy address RADD includes information about the mat that includes the redundancy cells to be refreshed and the main word lines.

The address arithmetic circuit 17 is electrically connected to the address selection circuit 15 and receives the selection address SADD from the address selection circuit 15. The address arithmetic circuit 17 generates an arithmetic address ARADD from the selection address SADD based on a row hammering control signal RHEN, a spacing setting signal N2SR, and a sequence signal SR2TH. The row hammering control signal RHEN is activated to perform a smart refresh operation. The smart refresh operation refers to a refresh operation performed on adjacent word lines to prevent or mitigate data loss of memory cells connected to the word lines adjacent to a target word line due to interference between the word lines according to successive access operations on the target word line. The spacing setting signal N2SR includes information used to set a spacing between the target word line and the adjacent word lines. The spacing setting signal N2SR is set at a first logic level when the spacing between the target word line and the adjacent word lines is a first spacing. For example, the first spacing is represented as "+1, -1," and when an N^{th} word line is the target word line, an (N+1) word line and an (N-1) word line are set as the adjacent word lines on which the smart refresh operation is performed. The spacing setting signal N2SR is set at a second logic level when the spacing between the target word line and the adjacent word lines is a second spacing. For example, the second spacing is represented as "+2, -2," and when the N^{th} word line is the target word line, an (N+2) word line and an (N-2) word line are set as the adjacent word lines on which the smart refresh operation is performed. The sequence signal SR2TH includes information about the adjacent word lines on which the smart refresh operation is performed. For example, when the sequence signal SR2TH is at a logic "low" level, the adjacent word line on which a first smart refresh operation is performed is designated, and when the sequence signal SR2TH is at a logic "high" level, the adjacent word line on which a second smart refresh operation is performed is designated. When the row hammering control signal RHEN is activated, and a first adjacent word line on which the first smart refresh operation is performed and a second adjacent word line on which the second smart refresh is performed are sequentially designated based on the spacing setting signal N2SR, the sequence signal SR2TH, and the selection address SADD, the address arithmetic circuit 17 sequentially generates the arithmetic addresses ARADD corresponding to the first adjacent word line and the second adjacent word line from the selection address SADD. For example, when the row hammering control signal RHEN is activated while an N^{th} word line is set as the target word line by the selection address SADD, the address arithmetic circuit 17 generates the arithmetic address ARADD corresponding to an (N+1) word line from the selection address SADD to perform the first smart refresh operation according to the spacing setting signal N2SR, the sequence signal SR2TH, and the selection address SADD, and generates the arithmetic address ARADD corresponding to an (N-1) word line from the selection address SADD to perform the second smart refresh operation.

The address arithmetic circuit 17 generates a redundancy switching signal OVS and a normal switching signal UND based on the row hammering control signal RHEN, the spacing setting signal N2SR, the sequence signal SR2TH, and the selection address SADD. The address arithmetic circuit 17 generates the redundancy switching signal OVS as activated when a normal word line connected to a normal cell is designated as the target word line and a redundancy word line connected to a redundancy cell is designated as the adjacent word line so that a smart refresh operation is performed based on the row hammering control signal RHEN, the spacing setting signal N2SR, the sequence signal SR2TH, and the selection address SADD. The normal cell refers to a memory cell in which a fail or defect has not occurred, and the redundancy cell refers to a memory cell replacing a defective memory cell. The address arithmetic circuit 17 generates the normal switching signal UND as activated when the redundancy word line connected to the redundancy cell is designated as the target word line, the normal word line connected to the normal cell is designated as the adjacent word line, and a smart refresh operation is performed, based on a row hammering control signal RHEN, a spacing setting signal N2SR, a sequence signal SR2TH, and a selection address SADD. In an embodiment, a normal word line is a word line that is connected to a normal cell. In an embodiment, a redundancy word line is a word line that is connected to a redundancy cell. In some embodiments, a target word line refers to a specific word line in a memory array that is currently being accessed or operated on. In another embodiment a target word line is a particular word line selected for a given operation (e.g., read, write, erase). In an embodiment, a redundancy switching signal may be a control signal used to redirect access from a defective memory cell to a redundancy cell. For example, when a defective memory cell is detected (e.g., due to a manufacturing defect or degradation over time), that defective memory cell is replaced by a redundancy cell using the redundancy switching signal. In one embodiment, when a smart refresh operation is performed, the memory device 1 identifies whether the target word line is defective. If the target word line is defective the memory device 1 activates the redundancy switching signal to reroute the refresh operation to the assigned redundancy word line connected to the redundancy cell instead of the defective memory cell.

The redundancy control circuit 19 is electrically connected to the fuse set 12, the address selection circuit 15, and the address arithmetic circuit 17, receives the repair information FET from the fuse set 12, receives the mat selection signal MSEL from the address selection circuit 15, and receives the redundancy switching signal OVS and the normal switching signal UND from the address arithmetic circuit 17. The redundancy control circuit 19 generates a redundancy activation signal REDUN based on the row hammering control signal RHEN, an active redundancy signal R-PRE, the mat selection signal MSEL, the repair information FET, the redundancy switching signal OVS, and the normal switching signal UND. The active redundancy signal R-PRE is activated when the redundancy word line is designated as the target word line. The active redundancy signal R-PRE is implemented as a signal generated by the fail confirmation signal generation circuit 13 in this embodiment, and the present disclosure is not limited to this embodiment.

The redundancy control circuit 19 generates the redundancy activation signal REDUN activated for a smart refresh operation on the redundancy word line when a repair operation is confirmed for the redundancy cells connected to the redundancy word line designated as the adjacent word line by the repair information FET while the normal word line is designated as the target word line, the redundancy word line is designated as the adjacent word line, and the redundancy switching signal OVS is activated in the mat selected by the mat selection signal MSEL. The redundancy control circuit 19 generates the redundancy activation signal REDUN deactivated when a repair operation is confirmed for the redundancy cells connected to the redundancy word line designated as the target word line by the repair information FET while the redundancy word line is designated as the target word line, the normal word line is designated as the adjacent word line, and the normal switching signal UND is activated in the mat selected by the mat selection signal MSEL.

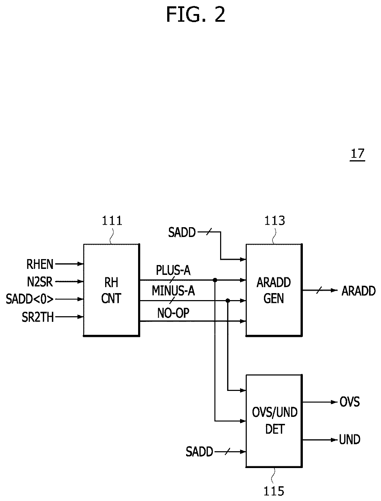

FIG. 2 illustrates an address arithmetic circuit 17 according to an embodiment of the present disclosure, for example, as shown in FIG. 1.

As shown in FIG. 2, the address arithmetic circuit 17 includes a row hammering control circuit (RH CNT) 111, an arithmetic address generation circuit (ARADD GEN) 113, and a switching detection circuit (OVS/UND DET) 115.

The row hammering control circuit 111 generates an addition signal PLUS-A, a subtraction signal MINUS-A, and a holding signal NO-OP based on a row hammering control signal RHEN, a spacing setting signal N2SR, a first bit of a selection address SADD<0>, and a sequence signal SR2TH. The first bit of the selection address SADD<0> designates a sequence to perform a smart refresh operation when a spacing between a target word line and adjacent word lines on which the smart refresh operation is performed is set as a first spacing. For example, when an N^{th} word line is a target word line, a first spacing is set to "+1, -1," and the first bit SADD<0> of the selection address is at a first logic level, the adjacent word line on which a first smart refresh operation is performed is set to an (N+1) word line corresponding to "+1", and the adjacent word line on which a second smart refresh operation is performed is set to an (N-1) word line corresponding to "-1". As another example, when the N^{th} word line is the target word line, the first spacing is set to "+1, -1," and the first bit SADD<0> of the selection address is at a second logic level, the adjacent word line on which the first smart refresh operation is performed is set to the (N-1) word line corresponding to "-1", and the adjacent word line on which the second smart refresh operation is performed is set to the (N+1) word line corresponding to "+1". When the spacing between the target word line and the adjacent word line on which the smart refresh operation is performed is set to the second spacing, the sequence to perform the smart refresh operation is designated regardless of the first bit SADD<0> of the selection address. For example, when the N^{th} word line is the target word line and the second spacing is set to "+2, -2," the adjacent word line on which the first smart refresh operation is performed is set to an (N+2) word line corresponding to "+2", and the adjacent word line on which the second smart refresh operation is performed is set to an (N-2) word line corresponding to "-2" regardless of a logic level of the first bit SADD<0> of the selection address.

The row hammering control circuit 111 generates the holding signal NO-OP as activated and the addition signal PLUS-A and the subtraction signal MINUS-A as deactivated when the smart refresh operation is not performed and the row hammering control signal RHEN is deactivated. The row hammering control circuit 111 generates the holding signal NO-OP as deactivated when the smart refresh operation is performed and the row hammering control signal RHEN is activated.

The row hammering control circuit 111 generates the addition signal PLUS-A as activated with a first logic bit set and the subtraction signal MINUS-A as deactivated when the smart refresh operation is performed while the N^{th} word line is the target word line and the (N+1) word line is set as the adjacent word line based on the row hammering control signal RHEN, the spacing setting signal N2SR, the first bit SADD<0> of the selection address, and the sequence signal SR2TH. The row hammering control circuit 111 generates the addition signal PLUS-A activated with a second logic bit set and the subtraction signal MINUS-A as deactivated when the smart refresh operation is performed while the N^{th} word line is the target word line and the (N+2) word line is set as the adjacent word line based on the row hammering control signal RHEN, the spacing setting signal N2SR, the first bit SADD<0> of the selection address, and the sequence signal SR2TH. The first logic bit set and the second logic bit set of the addition signal PLUS-A are different logic bit sets of bits included in the addition signal PLUS-A.

The row hammering control circuit 111 generates the addition signal PLUS-A as deactivated and the subtraction signal MINUS-A activated with the first logic bit set when the smart refresh operation is performed while the N^{th} word line is the target word line and the (N-1) word line is set as the adjacent word line based on the row hammering control signal RHEN, the spacing setting signal N2SR, the first bit SADD<0> of the selection address, and the sequence signal SR2TH. The row hammering control circuit 111 generates the addition signal PLUS-A as deactivated and the subtraction signal MINUS-A activated with the second logic bit set when the smart refresh operation is performed while the N^{th} word line is the target word line and the (N-2) word line is set as the adjacent word line based on the row hammering control signal RHEN, the spacing setting signal N2SR, the first bit SADD<0> of the selection address, and the sequence signal SR2TH. The first logic bit set and the second logic bit set of the subtraction signal MINUS-A are different logic bit sets of the bits included in the subtraction signal MINUS-A.

The arithmetic address generation circuit 113 is electrically connected to the row hammering control circuit 111 and receives the addition signal PLUS-A, the subtraction signal MINUS-A, and the holding signal NO-OP from the row hammering control circuit 111. The arithmetic address generation circuit 113 generates the arithmetic address ARADD from the selection address SADD based on the addition signal PLUS-A, the subtraction signal MINUS-A, and the holding signal NO-OP. The arithmetic address generation circuit 113 outputs the selection address SADD as the arithmetic address ARADD when the smart refresh operation is not performed and the holding signal NO-OP as activated is received. The arithmetic address generation circuit 113 adds the selection address SADD corresponding to the N^{th} word line to generate the arithmetic address ARADD corresponding to the (N+1) word line when the addition signal PLUS-A activated with the first logic bit set and the subtraction signal MINUS-A as deactivated are received in the smart refresh operation performed while the N^{th} word line is set as the target word line and the (N+1) word line is set as the adjacent word line. The arithmetic address generation circuit 113 adds the selection address SADD corresponding to the N^{th} word line to generate the arithmetic address ARADD corresponding to the (N+2) word line when the addition signal PLUS-A activated with the second logic bit set and the subtraction signal MINUS-A as deactivated are received in the smart refresh operation performed while the N^{th} word line is set as the target word line and the (N+2) word line is set as the adjacent word line. The arithmetic address generation circuit 113 subtracts the selection address SADD corresponding to the N^{th} word line to generate the arithmetic address ARADD corresponding to the (N-1) word line when the subtraction signal MINUS-A activated with the first logic bit set and the addition signal PLUS-A as deactivated are received in the smart refresh operation performed while the N^{th} word line is set as the target word line and the (N-1) word line is set as the adjacent word line. The arithmetic address generation circuit 113 subtracts the selection address SADD corresponding to the N^{th} word line to generate the arithmetic address ARADD corresponding to the (N-2) word line when the subtraction signal MINUS-A activated with the second logic bit set and the addition signal PLUS-A as deactivated are received in the smart refresh operation performed while the N^{th} word line is set as the target word line and the (N-2) word line is set as the adjacent word line.

The switching detection circuit 115 is electrically connected to the row hammering control circuit 111 and receives the addition signal PLUS-A and the subtraction signal MINUS-A from the row hammering control circuit 111. The switching detection circuit 115 generates a redundancy switching signal OVS and a normal switching signal UND based on the selection address SADD, the addition signal PLUS-A, and the subtraction signal MINUS-A. The switching detection circuit 115 generates the redundancy switching signal OVS as activated when a normal word line connected to a normal cell is designated as the target word line based on the selection address SADD, a redundancy word line connected to a redundancy cell is designated as the adjacent word line based on the addition signal PLUS-A and the subtraction signal MINUS-A, and the smart refresh operation is performed. The switching detection circuit 115 generates the normal switching signal UND as activated when the redundancy word line connected to the redundancy cell is designated as the target word line based on the selection address SADD, the normal word line connected to the normal cell is designated as the adjacent word line based on the addition signal PLUS-A and the subtraction signal MINUS-A, and the smart refresh is performed.

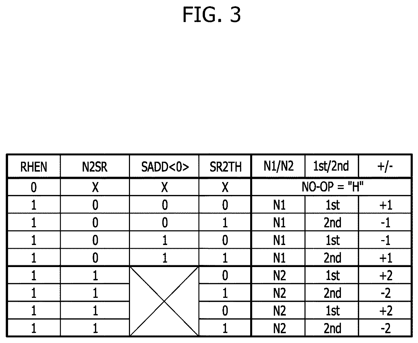

FIG. 3 is a table showing operations of a row hammering control circuit 111 according to an embodiment of the present disclosure, for example, as shown in FIG. 2.

As shown in a first row of the table, the row hammering control circuit 111 generates a holding signal NO-OP activated at a logic high level "H" when the smart refresh operation is not performed and the row hammering control signal RHEN is deactivated at binary bit "0". The binary bit "0" corresponds to a logic low level "L", and binary bit "1" corresponds to a logic high level "H".

As shown in a second row of the table, the row hammering control circuit 111 performs a first smart refresh operation on the adjacent word line set to the (N+1) word line corresponding to "+1" spaced apart from the target word line by a first spacing N1 when the N^{th} word line is the target word line, the smart refresh operation is performed so that the row hammering control signal RHEN is activated at binary bit "1", and the spacing setting signal N2SR, the first bit SADD<0> of the selection address, and the sequence signal SR2TH are set to binary bit set "000".

As shown in a third row of the table, the row hammering control circuit 111 performs a second smart refresh operation on the adjacent word line set to the (N-1) word line corresponding to "-1" spaced apart from the target word line by the first spacing N1 when the N^{th} word line is the target word line, the smart refresh operation is performed so that the row hammering control signal RHEN is activated at binary bit "1", and the spacing setting signal N2SR, the first bit SADD<0> of the selection address, and the sequence signal SR2TH are set to binary bit set "001".

As shown in a fourth row of the table, the row hammering control circuit 111 performs the first smart refresh operation on the adjacent word line set to the (N-1) word line corresponding to "-1" spaced apart from the target word line by the first spacing N1 when the N^{th} word line is the target word line, the smart refresh operation is performed so that the row hammering control signal RHEN is activated at binary bit "1", and the spacing setting signal N2SR, the first bit SADD<0> of the selection address, and the sequence signal SR2TH are set to binary bit set "010".

As shown in a fifth row of the table, the row hammering control circuit 111 performs a second smart refresh operation on the adjacent word line set to the (N+1) word line corresponding to "+1" spaced apart from the target word line by the first spacing N1 when the N^{th} word line is the target word line, the smart refresh is performed so that the row hammering control signal RHEN is activated at binary bit "1", and the spacing setting signal N2SR, the first bit SADD<0> of the selection address, and the sequence signal SR2TH are set to binary bit set "011".

As shown in a sixth row of the table, the row hammering control circuit 111 performs the first smart refresh on the adjacent word line set to the (N+2) word line corresponding to "+2" spaced apart from the target word line by a second spacing N2 when the N^{th} word line is the target word line, the smart refresh is performed so that the row hammering control signal RHEN is activated at binary bit "1", and the spacing setting signal N2SR and the sequence signal SR2TH are set to binary bit set "10". Also, when the spacing between the target word line and the adjacent word line on which the smart refresh operation is performed is set to the second spacing N2, the sequence to perform the smart refresh operation is designated regardless of the first bit SADD<0> of the selection address as indicated with the box including the "X."

As shown in a seventh row of the table, the row hammering control circuit 111 performs the second smart refresh operation on the adjacent word line set to the (N-2) word line corresponding to "-2" spaced apart from the target word line by the second spacing N2 when the N^{th} word line is the target word line, the smart refresh is performed so that the row hammering control signal RHEN is activated at binary bit "1", and the spacing setting signal N2SR and the sequence signal SR2TH are set to binary bit set "11". Also, when the spacing between the target word line and the adjacent word line on which the smart refresh operation is performed is set to the second spacing N2, the sequence to perform the smart refresh operation is designated regardless of the first bit SADD<0> of the selection address as indicated with the box including the "X."

As shown in an eighth row of the table, the row hammering control circuit 111 performs the first smart refresh on the adjacent word line set to the (N+2) word line corresponding to "+2" spaced apart from the target word line by the second spacing N2 when the N^{th} word line is the target word line, the smart refresh is performed so that the row hammering control signal RHEN is activated at binary bit "1", and the spacing setting signal N2SR and the sequence signal SR2TH are set to binary bit set "10". Also, when the spacing between the target word line and the adjacent word line on which the smart refresh operation is performed is set to the second spacing N2, the sequence to perform the smart refresh operation is designated regardless of the first bit SADD<0> of the selection address as indicated with the box including the "X."

As shown in a ninth row of the table, the row hammering control circuit 111 performs the second smart refresh operation on the adjacent word line set to the (N-2) word line corresponding to "-2" spaced apart from the target word line by the second spacing N2 when the N^{th} word line is the target word line, the smart refresh is performed so that the row hammering control signal RHEN is activated at binary bit "1", and the spacing setting signal N2SR and the sequence signal SR2TH are set to binary bit set "11". Also, when the spacing between the target word line and the adjacent word line on which the smart refresh operation is performed is set to the second spacing N2, the sequence to perform the smart refresh operation is designated regardless of the first bit SADD<0> of the selection address as indicated with the box including the "X."

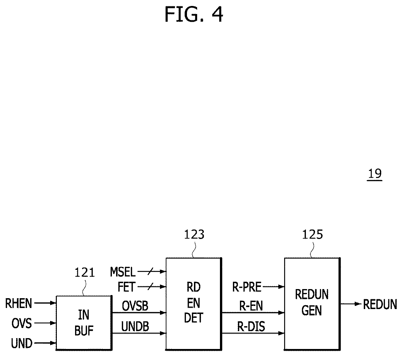

FIG. 4 illustrates a redundancy control circuit 19 according to an embodiment of the present disclosure, for example, as shown in FIG. 1.

As shown in FIG. 4, the redundancy control circuit 19 includes an input buffer (IN BUF) 121, a redundancy detection circuit (RD EN DET) 123, and a redundancy activation signal generation circuit (REDUN GEN) 125.

The input buffer 121 receives a row hammering control signal RHEN, a redundancy switching signal OVS, and a normal switching signal UND and generates a buffer redundancy switching signal OVSB and a buffer normal switching signal UNDB. The input buffer 121 buffers the redundancy switching signal OVS to generate the buffer redundancy switching signal OVSB when the row hammering control signal RHEN is activated for a smart refresh operation. The input buffer 121 buffers the normal switching signal UND to generate the buffer normal switching signal UNDB when the row hammering control signal RHEN is activated for the smart refresh operation.

The redundancy detection circuit 123 is electrically connected to the input buffer 121 and receives the buffer redundancy switching signal OVSB and the buffer normal switching signal UNDB from the input buffer 121. The redundancy detection circuit 123 generates a first redundancy control signal R-EN and a second redundancy control signal R-DIS based on the mat selection signal MSEL, the repair information FET, the buffer redundancy switching signal OVSB, and the buffer normal switching signal UNDB. The redundancy detection circuit 123 generates the first redundancy control signal R-EN as activated when a repair operation is confirmed for redundancy cells connected to a redundancy word line designated as an adjacent word line by the repair information FET in a mat selected by the mat selection signal MSEL and an activated buffer redundancy switching signal OVSB is received. The redundancy detection circuit 123 generates the second redundancy control signal R-DIS as activated when the repair operation is confirmed for the redundancy cells connected to the redundancy word line designated as the target word line by the repair information FET in the mat selected by the mat selection signal MSEL and an activated buffer normal switching signal UNDB is received.

The redundancy activation signal generation circuit 125 is electrically connected to the redundancy detection circuit 123 and receives the first redundancy control signal R-EN and the second redundancy control signal R-DIS from the redundancy detection circuit 123. The redundancy activation signal generation circuit 125 generates the redundancy activation signal REDUN based on the active redundancy signal R-PRE, the first redundancy control signal R-EN, and the second redundancy control signal R-DIS. The redundancy activation signal generation circuit 125 generates the redundancy activation signal REDUN as activated when a smart refresh operation is performed and the activated first redundancy control signal R-EN is received while a normal word line is designated as the target word line and a redundancy word line used in the repair operation is designated as the adjacent word line. The redundancy activation signal generation circuit 125 generates the redundancy activation signal REDUN as deactivated when a smart refresh operation is performed and the activated second redundancy control signal R-DIS is received while the redundancy word line is designated as the target word line and the normal word line is designated as the adjacent word line is received.

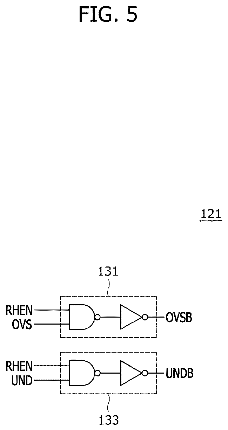

FIG. 5 illustrates an input buffer 121 according to an embodiment of the present disclosure, for example, as shown in FIG. 4.

As shown in FIG. 5, the input buffer 121 includes a first buffer 131 and a second buffer 133.

The first buffer 131 generates a buffer redundancy switching signal OVSB based on a row hammering control signal RHEN and a redundancy switching signal OVS. The first buffer 131 buffers the redundancy switching signal OVS to generate the buffer redundancy switching signal OVSB when the row hammering control signal RHEN is activated. In an embodiment, as shown in FIG. 5, the row hammering control signal RHEN and a redundancy switching signal OVS may be received by NAND gate. The result of the NAND gate may be output to an inverter to generate the buffer redundancy switching signal OVSB.

The second buffer 133 generates a buffer normal switching signal UNDB based on the row hammering control signal RHEN and a normal switching signal UND. The first buffer 131 buffers the normal switching signal UND to generate the buffer normal switching signal UNDB when the row hammering control signal RHEN is activated. In an embodiment, as shown in FIG. 5, the row hammering control signal RHEN and a normal switching signal UND may be received by NAND gate. The result of the NAND gate may be output to an inverter to generate the buffer normal switching signal UNDB.

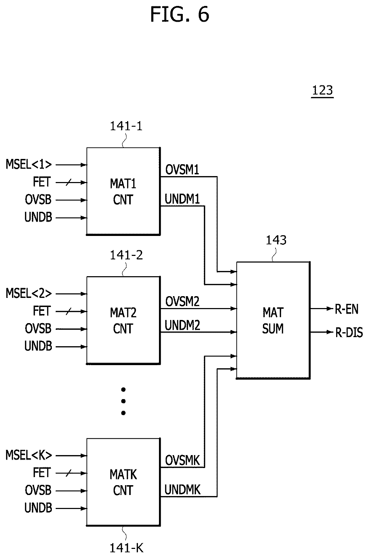

FIG. 6 illustrates a redundancy detection circuit 123 according to an embodiment of the present disclosure, for example, as shown in FIG. 4.

As shown in FIG. 6, the redundancy detection circuit 123 includes first mat control circuit (MAT1 CNT) 141-1 to K^{th} mat control circuit (MATK CNT) 141-K and a mat synthesis circuit (MAT SUM) 143.

The first mat control circuit 141-1 generates a first mat redundancy switching signal OVSM1 and a first mat normal switching signal UNDM1 based on a first bit MSEL<1> of a mat selection signal, repair information FET, a buffer redundancy switching signal OVSB, and a buffer normal switching signal UNDB. The first mat control circuit 141-1 generates the first mat redundancy switching signal OVSM1 as activated when a repair operation is confirmed for redundancy cells connected to a redundancy word line designated as an adjacent word line by the repair information FET in a first mat selected by the first bit MSEL<1> of the mat selection signal and the activated buffer redundancy switching signal OVSB is received. The first mat control circuit 141-1 generates the first mat normal switching signal UNDM1 as activated when a repair operation is confirmed for the redundancy cells connected to the redundancy word line designated as a target word line by the repair information FET in the first mat selected by the first bit MSEL<1> of the mat selection signal and the activated buffer normal switching signal UNDB is received.

The second mat control circuit 141-2 generates a second mat redundancy switching signal OVSM2 and a second mat normal switching signal UNDM2 based on a second bit MSEL<2> of the mat selection signal, the repair information FET, the buffer redundancy switching signal OVSB, and the buffer normal switching signal UNDB. The second mat control circuit 141-2 generates the second mat redundancy switching signal OVSM2 as activated when a repair operation is confirmed for the redundancy cells connected to the redundancy word line designated as the adjacent word line by the repair information FET in a second mat selected by the second bit MSEL<2> of the mat selection signal and the activated buffer redundancy switching signal OVSB is received. The second mat control circuit 141-2 generates the second mat normal switching signal UNDM2 as activated when a repair operation is confirmed for the redundancy cells connected to the redundancy word line designated as the target word line by the repair information FET in the second mat selected by the second bit MSEL<2> of the mat selection signal and the activated buffer normal switching signal UNDB is received.

The K^{th} mat control circuit 141-K generates a K^{th} mat redundancy switching signal OVSMK and a K^{th} mat normal switching signal UNDMK based on a K^{th} bit of the mat selection signal MSEL<K>, the repair information FET, the buffer redundancy switching signal OVSB, and the buffer normal switching signal UNDB. The K^{th} mat control circuit 141-K generates the K^{th} mat redundancy switching signal OVSMK as activated when a repair operation is confirmed for the redundancy cells connected to the redundancy word line designated as the adjacent word line by the repair information FET in the K^{th} mat selected by the K^{th} bit MSEL<K> of the mat selection signal and the activated buffer redundancy switching signal OVSB is received. The K^{th} mat control circuit 141-K generates the K^{th} mat normal switching signal UNDMK as activated when a repair operation is confirmed for the redundancy cells connected to the redundancy word line designated as the target word line by the repair information FET in the K^{th} mat selected by the K^{th} bit MSEL<K> of the mat selection signal and the activated buffer normal switching signal UNDB is received.

The mat synthesis circuit 143 is electrically connected to the first mat control circuit 141-1 to the K^{th} mat control circuit 141-K and receives the first mat redundancy switching signal OVSM1 to the K^{th} mat redundancy switching signal OVSMK and the first mat normal switching signal UNDM1 to the K^{th} mat normal switching signal UNDMK from the first mat control circuit 141-1 to the K^{th} mat control circuit 141-K. The mat synthesis circuit 143 generates the first redundancy control signal R-EN and the second redundancy control signal R-DIS based on the first mat redundancy switching signal OVSM1 to the K^{th} mat redundancy switching signal OVSMK and the first mat normal switching signal UNDM1 to the K^{th} mat normal switching signal UNDMK. The mat synthesis circuit 143 generates the first redundancy control signal R-EN activated to activate the redundancy activation signal REDUN when one of the first mat redundancy switching signal OVSM1 to the K^{th} mat redundancy switching signal OVSMK is activated. The mat synthesis circuit 143 generates the second redundancy control signal R-DIS that is activated to deactivate the redundancy activation signal REDUN when one of the first mat normal switching signal UNDM1 to the K^{th} mat normal switching signal UNDMK is activated.

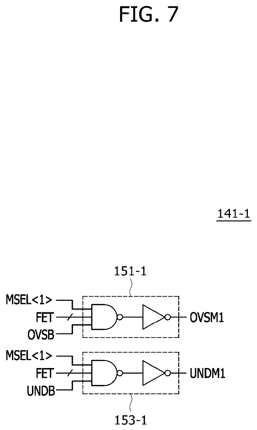

FIG. 7 illustrates an example of a first mat control circuit 141-1 according to an embodiment of the present disclosure, for example, as shown in FIG. 6.

As shown in FIG. 7, the first mat control circuit 141-1 includes a first redundancy buffer 151-1 and a first normal buffer 153-1.

The first redundancy buffer 151-1 generates a first mat redundancy switching signal OVSM1 based on a first bit MSEL<1> of a mat selection signal, repair information FET, and a buffer redundancy switching signal OVSB. The first redundancy buffer 151-1 generates the first mat redundancy switching signal OVSM1 activated at a logic high level when a repair operation is confirmed for the redundancy cells connected to the redundancy word line designated as the adjacent word line by the repair information FET at a logic high level in a first mat selected by the first bit MSEL<1> of the mat selection signal at a logic high level and the buffer redundancy switching signal OVSB activated at a logic high level is received. In an embodiment, as shown in FIG. 7, the first bit MSEL<1> of a mat selection signal, the repair information FET, and the buffer redundancy switching signal OVSB may be received by NAND gate. The result of the NAND gate may be output to an inverter to generate the first mat redundancy switching signal OVSM1.

The first normal buffer 153-1 generates the first mat normal switching signal UNDM1 based on the first bit MSEL<1> of the mat selection signal, the repair information FET, and the buffer normal switching signal UNDB. The first normal buffer 153-1 generates the first mat normal switching signal UNDM1 activated at a logic high level when a repair operation is confirmed for the redundancy cells connected to the redundancy word line designated as the target word line by the repair information FET at a logic high level in the first mat selected by the first bit MSEL<1> of the mat selection signal at a logic high level and the buffer normal switching signal UNDB activated at a logic high level is received. In an embodiment, as shown in FIG. 7, the first bit MSEL<1> of a mat selection signal, the repair information FET, and the buffer normal switching signal UNDB may be received by NAND gate. The result of the NAND gate may be output to an inverter to generate the first mat normal switching signal UNDM1.

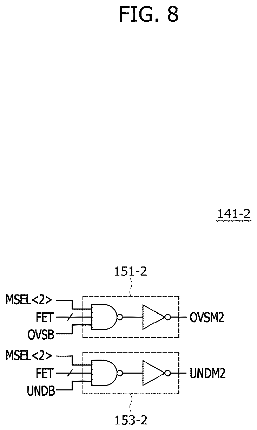

FIG. 8 illustrates an example of a second mat control circuit 141-2 according to an embodiment of the present disclosure, for example, as shown in FIG. 6.

As shown in FIG. 8, the second mat control circuit 141-2 includes a second redundancy buffer 151-2 and a second normal buffer 153-2.

The second redundancy buffer 151-2 generates a second mat redundancy switching signal OVSM2 based on a second bit MSEL<2> of a mat selection signal, repair information FET, and a buffer redundancy switching signal OVSB. The second redundancy buffer 151-2 generates the second mat redundancy switching signal OVSM2 activated at a logic high level when a repair operation is confirmed for the redundancy cells connected to the redundancy word line designated as the adjacent word line by the repair information FET at a logic high level in a second mat selected by the second bit MSEL<2> of the mat selection signal at a logic high level and the buffer redundancy switching signal OVSB activated at a logic high level is received. In an embodiment, as shown in FIG. 8, the second bit MSEL<2> of a mat selection signal, the repair information FET, and the buffer redundancy switching signal OVSB may be received by NAND gate. The result of the NAND gate may be output to an inverter to generate the second mat redundancy switching signal OVSM2.

The second normal buffer 153-2 generates a second mat normal switching signal UNDM2 based on the second bit MSEL<2> of the mat selection signal, the repair information FET, and the buffer normal switching signal UNDB. The second normal buffer 153-2 generates the second mat normal switching signal UNDM2 activated at a logic high level when a repair operation is confirmed for the redundancy cells connected to the redundancy word line designated as the target word line by the repair information FET at a logic high level in the second mat selected by the second bit MSEL<2> of the mat selection signal at a logic high level and the buffer normal switching signal UNDB activated at a logic high level is received. In an embodiment, as shown in FIG. 8, the second bit MSEL<2> of a mat selection signal, the repair information FET, and the buffer normal switching signal UNDB may be received by NAND gate. The result of the NAND gate may be output to an inverter to generate the second mat normal switching signal UNDM2.

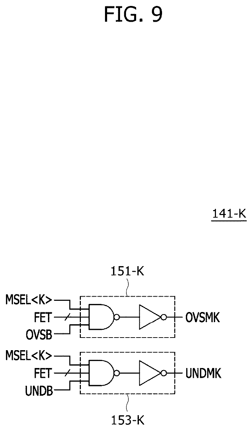

FIG. 9 illustrates an example of a K^{th} mat control circuit 141-K according to an embodiment of the present disclosure, for example, as shown in FIG. 6

As shown in FIG. 9, the K^{th} mat control circuit 141-K includes a K^{th} redundancy buffer 151-K and a K^{th} normal buffer 153-K.

The K^{th} redundancy buffer 151-K generates a K^{th} mat redundancy switching signal OVSMK based on a K^{th} bit MSEL<K> of a mat selection signal, repair information FET, and a buffer redundancy switching signal OVSB. The K^{th} redundancy buffer 151-K generates the K^{th} mat redundancy switching signal OVSMK activated at a logic high level when a repair operation on the redundancy cells connected to the redundancy word line designated as the adjacent word line by the repair information FET at a logic high level in the K^{th} mat selected by the K^{th} bit MSEL<K> of the mat selection signal at a logic high level and the buffer redundancy switching signal OVSB activated at a logic high level is received. In an embodiment, as shown in FIG. 9, the K^{th} bit MSEL<K> of a mat selection signal, the repair information FET, and the buffer redundancy switching signal OVSB may be received by NAND gate. The result of the NAND gate may be output to an inverter to generate the K^{th} mat redundancy switching signal OVSMK.

The K^{th} normal buffer 153-K generates a K^{th} mat normal switching signal UNDMK based on the K^{th} bit MSEL<K> of the mat selection signal, the repair information FET, and the buffer normal switching signal UNDB. The K^{th} normal buffer 153-K generates the K^{th} mat normal switching signal UNDMK activated at a logic high level when a repair operation is confirmed for the redundancy cells connected to the redundancy word line designated as the target word line by the repair information FET at a logic high level in the K^{th} mat selected by the K^{th} bit MSEL<K> of the mat selection signal at a logic high level and the buffer normal switching signal UNDB activated at a logic high level is received. In an embodiment, as shown in FIG. 9, the K^{th} bit MSEL<K> of a mat selection signal, the repair information FET, and the buffer normal switching signal UNDB may be received by NAND gate. The result of the NAND gate may be output to an inverter to generate the K^{th} mat normal switching signal UNDMK.

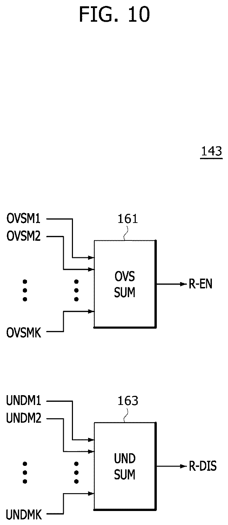

FIG. 10 illustrates an example of a mat synthetic circuit 143 according to an embodiment of the present disclosure, for example, as shown in FIG. 6.

As shown in FIG. 10, the mat synthesis circuit 143 includes a redundancy synthesis circuit (OVS SUM) 161 and a normal synthesis circuit (UND SUM) 163.

The redundancy synthesis circuit 161 generates a first redundancy control signal R-EN based on first mat redundancy switching signal OVSM1 to K^{th} mat redundancy switching signal OVSMK. The redundancy synthesis circuit 161 generates the first redundancy control signal R-EN activated to activate the redundancy activation signal REDUN when one of the first mat redundancy switching signal OVSM1 to K^{th} mat redundancy switching signal OVSMK is activated.

The normal synthesis circuit 163 generates a second redundancy control signal R-DIS based on the first mat normal switching signal UNDM1 to K^{th} mat normal switching signal UNDMK. The normal synthesis circuit 163 generates the second redundancy control signal R-DIS activated to deactivate the redundancy activation signal REDUN when one of the first mat normal switching signal UNDM1 to K^{th} mat normal switching signal UNDMK is activated.

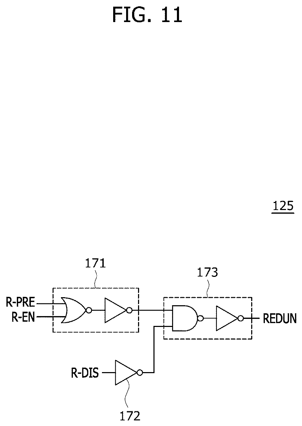

FIG. 11 illustrates an example of a redundancy activation signal generation circuit 125 according to an embodiment of the present disclosure, for example, as shown in FIG. 4.

As shown in FIG. 11, the redundancy activation signal generation circuit 125 includes a redundancy input circuit 171, an inverter 172, and an output buffer 173.

The redundancy input circuit 171 receives an active redundancy signal R-PRE and a first redundancy control signal R-EN and performs a logical OR operation. For example, as shown in FIG. 11 this is represented by coupling a NOR gate in series with an inverter. The redundancy input circuit 171 outputs a signal at a logic high level when one of the active redundancy signal R-PRE and the first redundancy control signal R-EN is activated at a logic high level. The active redundancy signal R-PRE is activated at a logic high level when a smart refresh operation is performed while the redundancy word line is designated as the target word line. The first redundancy control signal R-EN is activated at a logic high level when a smart refresh operation is performed while the normal word line is designated as the target word line and the redundancy word line used in a repair operation is designated as the adjacent word line.

The output buffer 173 receives an output signal of the redundancy input circuit 171 and an output signal of the inverter 172 that inverts a second redundancy control signal R-DIS and performs a logical AND operation. For example, as shown in FIG. 11 this is represented by coupling a NAND gate in series with an inverter. The output buffer 173 generates a redundancy enable signal REDUN activated at a logic high level for a smart refresh operation on the redundancy word line when one of the active redundancy signal R-PRE and the first redundancy control signal R-EN is activated at a logic high level while the second redundancy control signal R-DIS is deactivated at a logic low level. The output buffer 173 generates the redundancy activation signal REDUN deactivated at a logic low level based on the output signal of the inverter 172 set at a logic low level when the second redundancy control signal R-DIS is activated at a logic high level. The second redundancy control signal R-DIS is activated at a logic high level to deactivate the redundancy activation signal REDUN.

FIG. 12 to FIG. 17 illustrate smart refresh operations performed in mats according to an embodiment of the present disclosure.

As shown in FIG. 12, when a second main word line MWL2 is designated as a target word line by a selection address SADD and a first redundancy word line RWL1 is designated as an adjacent word line by an arithmetic address ARADD while a mat selection signal MSEL<K> is set at a logic high level "H" for a smart refresh operation on a K^{th} mat and a first redundancy word line RWL1 is used for a repair operation so that a repair information FET<1> is set at a logic high level "H", a redundancy activation signal REDUN is activated at a logic high level "H" and the smart refresh operation is performed. That is, even when the target word line is the second main word line MWL2 that is a normal word line and the adjacent word line is the first redundancy word line RWL1 that is a redundancy word line used for the repair operation, the smart refresh operation is performed by activating the redundancy activation signal REDUN.

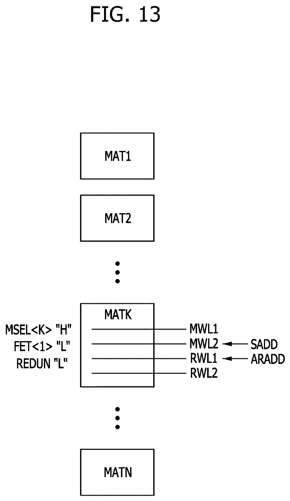

As shown in FIG. 13, when the second main word line MWL2 is designated as the target word line by the selection address SADD and the first redundancy word line RWL1 is designated as the adjacent word line by the arithmetic address ARADD while the mat selection signal MSEL<K> is set at a logic high level "H" for the smart refresh operation on the K^{th} mat and the first redundancy word line RWL1 is not used for the repair operation so that the repair information FET<1> is set at a logic low level "L", the redundancy activation signal REDUN is deactivated at a logic low level "L" and the smart refresh operation is not performed.

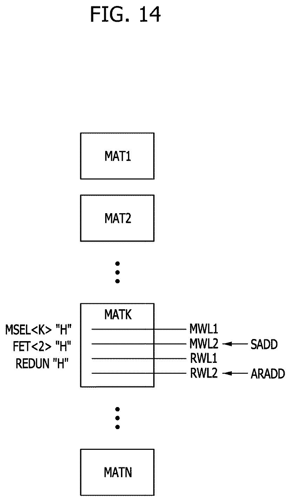

As shown in FIG. 14, when the second main word line MWL2 is designated as the target word line by the selection address SADD and a second redundancy word line RWL2 is designated as the adjacent word line by the arithmetic address ARADD while the mat selection signal MSEL<K> is set at a logic high level "H" for the smart refresh operation on the K^{th} mat and the second redundancy word line RWL2 is used for the repair operation so that the repair information FET<2> is set at a logic high level "H", the redundancy activation signal REDUN is activated at a logic high level "H" and the smart refresh operation is performed. That is, even when the target word line is the second main word line MWL2 that is the normal word line and the adjacent word line is the second redundancy word line RWL2 that is the redundancy word line used for the repair operation, the smart refresh operation is performed by activating the redundancy activation signal REDUN.

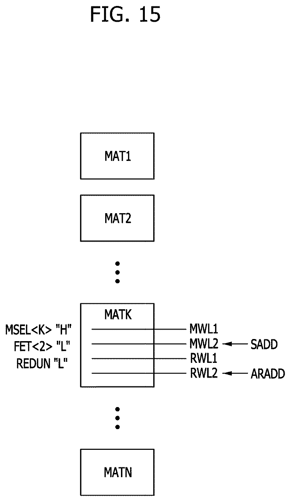

As shown in FIG. 15, when the second main word line MWL2 is designated as the target word line by the selection address SADD and the second redundancy word line RWL2 is designated as the adjacent word line by the arithmetic address ARADD while the mat selection signal MSEL<K> is set at a logic high level "H" for the smart refresh operation on the K^{th} mat and the second redundancy word line RWL2 is not used for the repair operation so that the repair information FET<2> is set at a logic low level "L", the redundancy activation signal REDUN is deactivated at a logic low level "L" and the smart refresh operation is not performed.

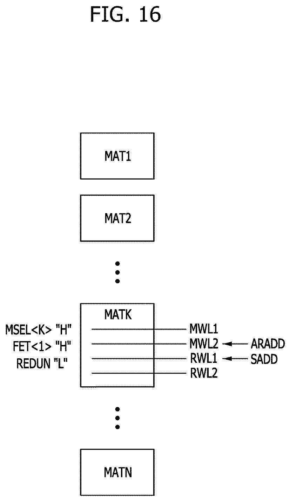

As shown in FIG. 16, when the first redundancy word line RWL1 is designated as the target word line by the selection address SADD and the second main word line MWL2 is designated as the adjacent word line by the arithmetic address ARADD while the mat selection signal MSEL<K> is set at a logic high level "H" for the smart refresh operation on the K^{th} mat and the first redundancy word line RWL1 is used for the repair operation so that the repair information FET<1> is set at a logic high level "H", the redundancy activation signal REDUN is deactivated at a logic low level "L" and the smart refresh operation is not performed.

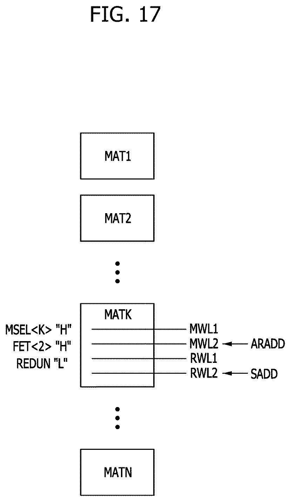

As shown in FIG. 17, when the second redundancy word line RWL2 is designated as the target word line by the selection address SADD and the second main word line MWL2 is designated as the adjacent word line by the arithmetic address ARADD while the mat selection signal MSEL<K> is set at a logic high level "H" for the smart refresh operation on the K^{th} mat and the second redundancy word line RWL2 is used for the repair operation so that the repair information FET<2> is set at a logic high level "H", the redundancy activation signal REDUN is deactivated at a logic low level "L" and the smart refresh operation is not performed.

FIG. 18 illustrates a memory system 2 according to an embodiment of the present disclosure.

As shown in FIG. 18, the memory system 2 includes a printed circuit board (PCB) 21, a substrate 23, an interposer 25, a memory device 27, and a processor 29.

The printed circuit board 21 connects various electronic components to each other to form electronic circuits. The electronic circuits include the memory system 2. A copper (Cu) layer, a solder mask, a silk screen, and so forth are formed on the printed circuit board 21. Circuit paths that transmit or transfer signals or power are formed in the copper (Cu) layer. The solder mask prevents damage to the circuits and protects a specific region where components are soldered. The silk screen indicates location or information for the electronic components as characters or symbols printed on a surface of the printed circuit board 21.

The substrate 23 is disposed over the printed circuit board 21 with bump pads in between, for example, bump pads 211 that mechanically support the interposer 25, the memory device 27, and the processor 29. The substrate 23 functions as a physical base for the printed circuit board 21 and is an insulator. The substrate 23 may include materials such as FR4 that is an insulator made of fiberglass and epoxy resin, ceramics that can withstand high temperatures, have appropriate thermal conductivity properties, and are used in high-frequency circuits, polyimide that is used as a basic material for flexible PCBs due to flexible characteristics, and the like.

The interposer 25 is disposed over the substrate 23 with bump pads in between and includes wiring that connects electronic components, for example, the memory device 27 and the processor 29, that have form factors or pin arrangements do not match or have different spacing. The interposer 25 converts signals from different interfaces, such as double data rate (DDR), high bandwidth memory (HBM), peripheral component interconnect express (PCle).

The memory device 27 is disposed over the interposer 25 with pads in between, for example, micro bump pads 213. The memory device 27 stores data received from the processor 29 or outputs the stored data to the processor 29 under control of the processor 29. The memory device 27 includes a base die 220 and a plurality of core dies 221-1 to 221-L, where L is an integer greater than 1. The core dies 221-1 to 221-L are stacked over the base die 220 with micro bump pads in between. The base die 220 and the core dies 221-1 to 221-L are vertically connected to each other using through vias and micro bump pads. The base die 220 controls efficient data transmission between the processor 29 and the core dies 221-1 to 221-L. The base die 220 receives input/output power voltage (voltage drain drain for IO also referred to as output stage drain power voltage) VDDQ as an operating voltage utilized during operation of internal circuits included in the base die 220. The base die 220 receives the input/output power voltage VDDQ from the printed circuit board 21 through the substrate 23 and the interposer 25. The input/output power voltage VDDQ is a voltage supplied to buffers that transmit data and is distinguished or different from the power supply voltage VDD. The core dies 221-1 to 221-L use a peripheral voltage VPERI as an operating voltage during operation of the internal circuits included in the core dies 221-1 to 221-L. The core dies 221-1 to 221-L generate the peripheral voltage VPERI from the input/output power voltage VDDQ received through the base die 220. The core dies 221-1 to 221-L generate the peripheral voltage VPERI at a lower voltage level than the input/output power voltage VDDQ and use the peripheral voltage VPERI as an operating voltage. Each of the core dies 221-1 to 221-L includes a plurality of channel regions, for example, eight channel regions or sixteen channel regions that operate independently. Each of the plurality of channel regions is allocated with a channel operating independently to receive or transmit data. The number L of core dies 221-1 to 221-L may be four, eight, twelve, sixteen, and so forth. For example, when each of the core dies 221-1 to 221-12 has eight channels, the core dies 221-1 to 221-4, the core dies 221-5 to 221-8, and the core dies 221-9 to 221-12 each include thirty two channel regions, and transmit and receive data with the processor 29 in units of a rank including thirty two channels.

The memory device 27 is implemented with the memory device 1 illustrated in FIG. 1. In a smart refresh operation in which a refresh operation is performed on an adjacent word line adjacent to a target word line, when the target word line is a normal word line and the adjacent word line is a redundancy word line, the memory device 27 can perform a smart refresh operation at a boundary between the normal word line and the redundancy word line by activating access to a redundancy cell so that the refresh operation can be performed on the redundancy word line.

Concepts are disclosed in conjunction with various examples and embodiments. Those skilled in the art will understand that various modifications, additions, and substitutions are possible without departing from the scope and technical concepts of the present disclosure. The embodiments disclosed in the present specification should be considered from an illustrative standpoint and not a restrictive standpoint. The scope of the present disclosure is not limited to the descriptions. All changes within the meaning and range of equivalency of the claims are included within their scope.

## Claims

1. A memory device comprising:
an address arithmetic circuit configured to generate a redundancy switching signal when a normal word line connected to a normal cell is designated as a target word line and a redundancy word line connected to a redundancy cell is designated as an adjacent word line so that a smart refresh operation is performed; and
a redundancy control circuit configured to generate a redundancy activation signal based on the redundancy switching signal.

2. The memory device of claim 1,
wherein the adjacent word line includes a first adjacent word line and a second adjacent word line; and
wherein the address arithmetic circuit is configured to:
generate, from a selection address, an arithmetic address corresponding to the first adjacent word line on where a first smart refresh operation is performed on; and
generate, from the selection address, an arithmetic address corresponding to the second adjacent word line on where a second smart refresh operation is performed on.

3. The memory device of claim 2, further comprising:
a fail confirmation signal generation circuit configured to compare a buffer address with a fail address to generate a fail confirmation signal, the buffer address generated by buffering an address input for a refresh operation; and
an address selection circuit configured to output one of the buffer address and a redundancy address as the selection address based on the fail confirmation signal.

4. The memory device of claim 3, wherein the address selection circuit outputs a mat selection signal used to select a mat where the refresh operation is performed on.

5. The memory device of claim 2, wherein, when the target word line is the normal word line and the first adjacent word line is a first redundancy word line located at a first spacing from the target word line, the address arithmetic circuit generates the redundancy switching signal as activated for a first smart refresh operation on the first adjacent word line.

6. The memory device of claim 5, wherein the redundancy control circuit generates the redundancy activation signal as activated for the first smart refresh operation when the redundancy switching signal is activated.

7. The memory device of claim 5, wherein, when the second adjacent word line is a second redundancy word line located at the first spacing from the target word line, the address arithmetic circuit generates the redundancy switching signal as activated for a second smart refresh operation on the second adjacent word line.

8. The memory device of claim 7, wherein the redundancy control circuit generates the redundancy activation signal as activated for the second smart refresh operation when the redundancy switching signal is activated.

9. The memory device of claim 2, wherein, when the target word line is the normal word line and the first adjacent word line is a first redundancy word line located at a second spacing from the target word line, the address arithmetic circuit generates the redundancy switching signal as activated for a first smart refresh operation on the first adjacent word line.

10. The memory device of claim 9, wherein the redundancy control circuit generates the redundancy activation signal as activated for the first smart refresh operation when the redundancy switching signal is activated.

11. The memory device of claim 9, wherein, when the second adjacent word line is a second redundancy word line located at the second spacing from the target word line, the address arithmetic circuit generates the redundancy switching signal as activated for a second smart refresh operation on the second adjacent word line.

12. The memory device of claim 11, wherein the redundancy control circuit generates the redundancy activation signal as activated for the second smart refresh operation when the redundancy switching signal is activated.

13. The memory device of claim 1, wherein the address arithmetic circuit generates a normal switching signal when the redundancy word line is designated as the target word line and the normal word line is designated as the adjacent word line so that the smart refresh operation is performed.

14. The memory device of claim 13, wherein the redundancy control circuit generates the redundancy activation signal as deactivated based on the normal switching signal.

15. A memory device comprising:
a row hammering control circuit configured to generate an addition signal, a subtraction signal, and a holding signal based on a row hammering control signal, a spacing setting signal, a selection address, and a sequence signal;
an arithmetic address generation circuit configured to generate an arithmetic address from the selection address based on the addition signal, the subtraction signal, and the holding signal; and
a switching detection circuit configured to generate a redundancy switching signal and a normal switching signal based on the selection address, the addition signal, and the subtraction signal.

16. The memory device of claim 15, wherein the row hammering control circuit receives the row hammering control signal as activated for a smart refresh operation on an adjacent word line adjacent to a target word line.

17. The memory device of claim 16, wherein the row hammering control circuit generates the hold signal as activated when the smart refresh operation is not performed and the row hammering control signal deactivated is received.

18. The memory device of claim 16, wherein the row hammering control circuit receives the spacing setting signal used to set a spacing between the target word line and the adjacent word line.

19. The memory device of claim 16,
wherein the adjacent word line includes a first adjacent word line and a second adjacent word line; and
wherein the row hammering control circuit generates the addition signal and the subtraction signal that control a sequence of the smart refresh operations on the first adjacent word line and the second adjacent word line based on the selection address and the sequence signal.

20. The memory device of claim 19, wherein, when a spacing between the target word line and the first adjacent word line is a first spacing, the row hammering control circuit generates the addition signal as activated with a first logic bit set and the subtraction signal as deactivated, based on the selection address and the sequence signal to perform a first smart refresh operation.

21. The memory device of claim 20, wherein the arithmetic address generation circuit generates the arithmetic address to perform the first smart refresh operation on the first adjacent word line when the addition signal is activated with the first logic bit set.

22. The memory device of claim 20, wherein the switching detection circuit generates the redundancy switching signal as activated when the target word line by the selection address is a normal word line and the first adjacent word line is a redundancy word line.

23. The memory device of claim 20, wherein the row hammering control circuit generates the addition signal as deactivated and the subtraction signal as activated with a second logic bit set based on the selection address and the sequence signal to perform a second smart refresh operation after the first smart refresh operation is performed.

24. The memory device of claim 23, wherein the arithmetic address generation circuit generates the arithmetic address to perform the second smart refresh operation on the second adjacent word line when the subtraction signal is activated with the second logic bit set.

25. The memory device of claim 23, wherein the switching detection circuit generates the redundancy switching signal as activated when the target word line by the selection address is a normal word line and the second adjacent word line is a redundancy word line.

26. The memory device of claim 19,
wherein the row hammering control circuit generates the subtraction signal as activated with a first logic bit set and the addition signal as deactivated based on the selection address and the sequence signal to perform a first smart refresh operation when a spacing between the target word line and the second adjacent word line is a first spacing;
wherein the arithmetic address generation circuit generates the arithmetic address to perform the first smart refresh operation on the second adjacent word line when the subtraction signal is activated with the first logic bit set; and
wherein the switching detection circuit generates the redundancy switching signal as activated when the target word line by the selection address is a normal word line and the second adjacent word line is a redundancy word line.

27. The memory device of claim 26,
wherein the row hammering control circuit generates the addition signal as activated with a second logic bit set and the subtraction signal as deactivated based on the selection address and the sequence signal to perform a second smart refresh operation after the first smart refresh operation is performed;
wherein the arithmetic address generation circuit generates the arithmetic address to perform the second smart refresh operation on the first adjacent word line when the addition signal is activated with the second logic bit set; and
wherein the switching detection circuit generates the redundancy switching signal as activated when the target word line by the selection address is a normal word line and the first adjacent word line is a redundancy word line.

28. The memory device of claim 19,
wherein the row hammering control circuit generates the addition signal as activated with a first logic bit set and the subtraction signal deactivated based on the sequence signal to perform a first smart refresh operation when a spacing between the target word line and the first adjacent word line is a second spacing;
wherein the arithmetic address generation circuit generates the arithmetic address to perform the first smart refresh operation on the first adjacent word line when the addition signal is activated with the first logic bit set; and
wherein the switching detection circuit generates the redundancy switching signal as activated when the target word line by the selection address is a normal word line and the first adjacent word line is a redundancy word line.

29. The memory device of claim 28,
wherein the row hammering control circuit generates the subtraction signal as activated with a second logic bit set and the addition signal as deactivated based on the sequence signal to perform a second smart refresh operation when a spacing between the target word line and the second adjacent word line is a second spacing;
wherein the arithmetic address generation circuit generates the arithmetic address to perform the second smart refresh operation on the second adjacent word line when the subtraction signal is activated with the second logic bit set; and
wherein the switching detection circuit generates the redundancy switching signal as activated when the target word line by the selection address is a normal word line and the second adjacent word line is a redundancy word line.

30. The memory device of claim 15, further comprising a redundancy control circuit configured to generate a redundancy activation signal as activated for a smart refresh operation on a redundancy word line based on the row hammering control signal, the redundancy switching signal, the normal switching signal, a mat selection signal, and repair information

31. The memory device of claim 30, wherein the redundancy control circuit generates the redundancy activation signal as activated when a repair operation is confirmed for redundancy cells connected to the redundancy word line by the repair information while a normal word line is designated as a target word line and the redundancy word line is designated as an adjacent word line in a mat selected by the mat selection signal so that the redundancy switching signal is activated.

32. The memory device of claim 30, wherein the redundancy control circuit generates the redundancy activation signal as deactivated when a repair operation is confirmed for redundancy cells connected to the redundancy word line by the repair information while the redundancy word line is designated as a target word line and a normal word line is designated as an adjacent word line in the mat selected by the mat selection signal so that the normal switching signal is activated.

33. A method of performing a refresh operation, the method comprising:
generating a redundancy switching signal as activated for a first smart refresh operation on a first adjacent word line when a target word line is a normal word line and the first adjacent word line is a first redundancy word line located at a set spacing from the target word line; and
generating a redundancy activation signal as activated for the first smart refresh operation when the redundancy switching signal is activated.

34. The method of claim 33, further comprising generating the redundancy switching signal as activated for a second smart refresh operation on a second adjacent word line when the second adjacent word line is a second redundancy word line located at the set spacing from the target word line.

35. The method of claim 34, further comprising generating the redundancy activation signal as activated for the second smart refresh operation when the redundancy switching signal is activated.
